(19) Europäisches Patentamt / European Patent Office / Office européen des brevets

(11) **EP 3 206 041 A1**

(12) **EUROPEAN PATENT APPLICATION**

(43) Date of publication:
**16.08.2017 Bulletin 2017/33**

(51) Int Cl.:
**G01R 31/12** *(2006.01)*  **G01R 31/02** *(2006.01)*

(21) Application number: **16184275.2**

(22) Date of filing: **16.08.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **ABB Schweiz AG**
**5400 Baden (CH)**

(72) Inventor: **STENESTAM, Bengt-Olof**
**771 42 Ludvika (SE)**

(74) Representative: **Savela, Reino Aleksi**
**ABB AB**
**Intellectual Property**
**Forskargränd 7**
**721 78 Västerås (SE)**

(54) **A SYSTEM AND A METHOD FOR MONITORING TRANSFORMER BUSHINGS**

(57) The present invention relates to a system and method for monitoring transformer bushings (100,302a-c) in a three phase transformer, wherein each transformer bushing comprises a sensor device (308a-c,408a-c). The method comprising measuring (501) signals from said sensor device, calculating (502) a measurement vector for each of said three transformer bushings from the corresponding measured signal, wherein the magnitude of the respective measurement vector of a transformer bushing is the measurement, and the direction of the measurement vector is selected such that the three measurement vectors are evenly angularly distributed on the unit circle with an angular difference of $2/3 \times \pi$ between adjacent measurement vectors calculating (503) a vector sum of the three measurement vectors. The method further comprises determining (504) if the magnitude of the vector sum is larger than a predetermined value, then issue an alarm (505).

Fig. 3

EP 3 206 041 A1

**Description**

**TECHNICAL FIELD**

The embodiments described herein relate to a system and a method for monitoring a plurality of transformer bushings, and in particular to a system and a method which measures parameters of a test tap adapter connected to a transformer bushing.

**BACKGROUND**

A modern high voltage transformer is preferably closely monitored by a monitoring system that employs several different methods for monitoring the status of the transformer. Some of the methods are aimed at testing the transformer using off-line methods which involves subjecting the transformer to different forms of stimuli. Other methods involve in-situ measurements and monitoring during normal use. These measurements may involve temperature measurements during different loads. It is of great interest to monitor the transformer bushings, which connects the incoming high voltage to the coils of the transformer. The transformer bushings often comprise a center conductor with several layers of oil impregnated paper (OIP) wrapping. The transformer bushing acts as a capacitor and if for example a short circuit is formed between two layers of paper the oil is carbonized and a permanent damage occurs in the bushing.

Transformer bushings are subjected to high dielectric and thermal stresses, and bushing failures are one of the leading causes of forced outages and transformer failures. The two most common bushing failure mechanisms are moisture contamination and partial discharge. Moisture usually enters the bushings via deterioration of gasket material or cracks in thermal connections resulting in an increase in the dielectric loss and insulation power factor. Tracking over the surface or burning through the condenser core is typically associated with partial discharge.

A very sensitive method for measuring power factor and capacitance of transformer bushings is the sum current method. The basic principle of the sum current method is based on the fact that the sums of the voltage and current phasors are zero in a symmetrical three phase system. Therefore, analysis of bushing conditions can be performed by vectorially adding currents from the capacitance or power factor taps. If the bushings are identical and the system voltages are perfectly balanced the sum current will equal to zero. In reality, the bushings are never identical and system voltages are never perfectly balanced. As a result the sum current is a non-zero value and is unique for each set of bushings. In order to analyze data from sum current measurements it is common to use various types of software such as expert systems and different filtering methods.

Within the art it is also common to utilize off-line measurements of the loss tangent ($\tan\delta$) which is representative of dielectric losses in the transformer bushing.

Sometimes, a change in capacitance of the transformer bushing is not reflected in a change of dielectric losses of the transformer bushing.

It is thus a need in the art for an improved on-line measuring method and system that obviates at least some of the problems outlined in connection with known solutions.

**SUMMARY**

It is an object to provide a method and a system which improves the monitoring of a plurality of transformer bushings.

The above stated object is achieved by means of a method and a system according to the independent claims.

A first embodiment provides a method for monitoring transformer bushings of a three phase transformer, wherein each transformer bushing comprises a sensor device. The method comprising measuring signals from said sensor device, calculating a measurement vector for each of said three transformer bushings from the corresponding measured signal, wherein the magnitude of the respective measurement vector of a transformer bushing is the measurement, and the direction of the measurement vector is selected such that the three measurement vectors are evenly angularly distributed on the unit circle with an angular difference of $2/3\times\pi$ between adjacent measurement vectors. The method further comprises calculating a vector sum of the three measurement vectors, and determining if the magnitude of the vector sum is larger than a predetermined value, then issue an alarm.

A second embodiment provides a system for monitoring transformer bushings of a three phase transformer, wherein each transformer bushing comprises a respective sensor device. The system comprising a measuring device for measuring signals from said sensor devices; and a processing means configured for calculating measurement vector for each of said three transformer bushings from the corresponding measured signal. The magnitude of the respective measurement vector of a transformer bushing is the measurement, and the direction of the measurement vector is selected such that the three measurement vectors are evenly angularly distributed on the unit circle with an angular difference of $2/3\times\pi$ between adjacent measurement vectors. The system further comprises calculating a vector sum of the of the three measurement vectors, and determining if the magnitude of the vector sum is larger than a predetermined value, then issue an alarm.

An advantage of certain embodiments described herein is that they make it possible to monitor the capacitances of the transformer bushings in an efficient way.

Further advantages and features of embodiments of the present invention will become apparent when reading the following detailed description in conjunction with the drawings.

**BRIEF DESCRIPTION OF THE DRAWINGS**

Fig. 1 a-b are schematic drawings of transformer bushings.

Fig. 2 is circuit drawings of equivalent circuits for a transformer bushing with a test tap adapter.

Fig. 3 is a schematic block diagram of a system according to an embodiment.

Fig. 4 is a schematic block diagram of a system according to an embodiment.

Fig. 5 is a flow diagram illustrating an embodiment of a method for monitoring a transformer bushing.

**DETAILED DESCRIPTION**

The present invention will now be described more fully hereinafter with reference to the accompanying drawings, in which different exemplary embodiments are shown. These exemplary embodiments are provided so that this disclosure will be thorough and complete and not for purposes of limitation.

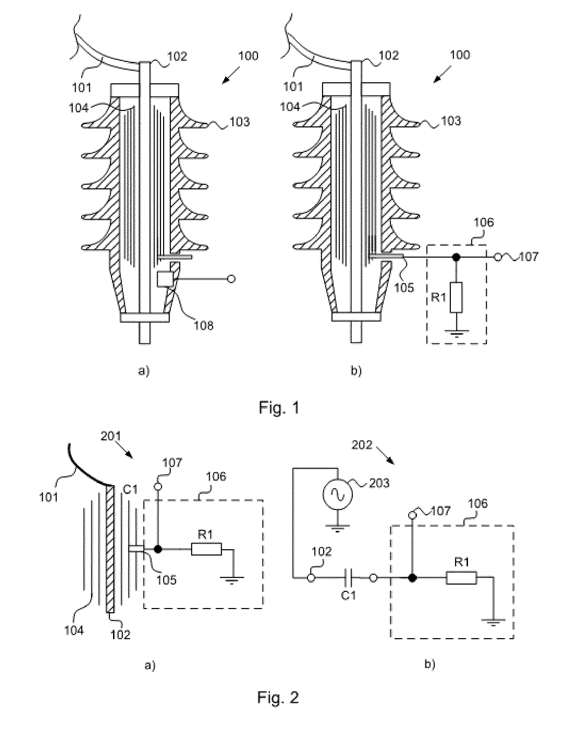

Fig. 1 a illustrates a transformer bushing, generally designated 100. The transformer bushing 100 is provided for allowing connection from an incoming high voltage power line 101 to a transformer core (not shown) via a center core 102 of the transformer bushing 100. The outer surface of the transformer often is at ground potential. This causes large electrical field to form and the transformer bushing 100 must be able to withstand these electrical fields without burning or arcing. The transformer bushing 100 comprises an outer insulator 103 usually made of a ceramic, such as porcelain. Around the center core 102 are several layers of oil impregnated paper (OIP) 104 wrapped and form a capacitor. Furthermore, the transformer bushing has a sensor device 108 configured to measure a property of the transformer bushing. Such properties may for example be pressure, temperature or capacitance of the transformer bushing.

In one embodiment of a transformer bushing shown in Fig. 1b a test tap adapter 105 is arranged in an opening in the outer insulator 103. The test tap adapter 105 provides an electrical connection to a layer of the wrapped OIP, which means that a part of the capacitor formed by the center core 102 and the wrapping of OIP will be connectable to the outside and a fraction of the high voltage at the center core 102 will be available at the test tap adapter 105. The outer insulator is often filled with transformer oil, which means that the OIP will be embedded in oil.

The test tap adapter 105 is connected to a load circuit 106, which in a preferred embodiment comprises a resistor R1 connected to a potential, which in a preferred embodiment is ground potential. The test tap adapter is further connected to a test tap terminal 107. In this embodiment the sensor device comprises the test tap adapter 105 and the load circuit 106.

An equivalent circuit 201 of the test tap adapter 105, the load circuit 106 and the test tap terminal 107 is shown in Fig. 2a). In this figure the incoming high voltage line 101 is connected to the center core 102. Around the center core is the OIP 104 wrapped and a connection from one of the wrapped layers is connected to the test tap adapter 105. This way a part C1 of the capacitance C of the transformer bushing is connected to the test tap adapter. The relation between the total capacitance and the number of OIP layers is: C'=C/N, where C' is the capacitance between the test tap adapter and the center core, C is the total capacitance of the transformer bushing, and N is the number of layers.

In Fig. 2b the final equivalent circuit, generally designated 202, is illustrated. The capacitance C' is the fractional capacitance of C. The test tap terminal 107 is further connected to ground potential via the resistor R1. In this equivalent circuit is a high voltage source 203 connected to the center core 102. The high voltage source supplies a high-voltage HV to the center core 102. The voltage drop over the resistor R1 is U. An equation for the voltages in the equivalent circuit can be derived as:

$$C'=U/(\omega \times R \times HV) \hspace{5cm} (eq1)$$

Where C' is the capacitance between the center core 102 and the test tap adapter 105, $\omega$ is equal $2 \times \pi \times f$, where f is the frequency of the high voltage source. R is the resistance of the resistor R1.

In another embodiment may the resistor R1 be connected to a potential other than ground potential, but in a preferred embodiment the resistor R1 is connected to ground potential.

The above equation (eq1) may be used to calculate the capacitance C1 using the measured voltage U of the test tap adapter and the voltage V supplied to the center core.

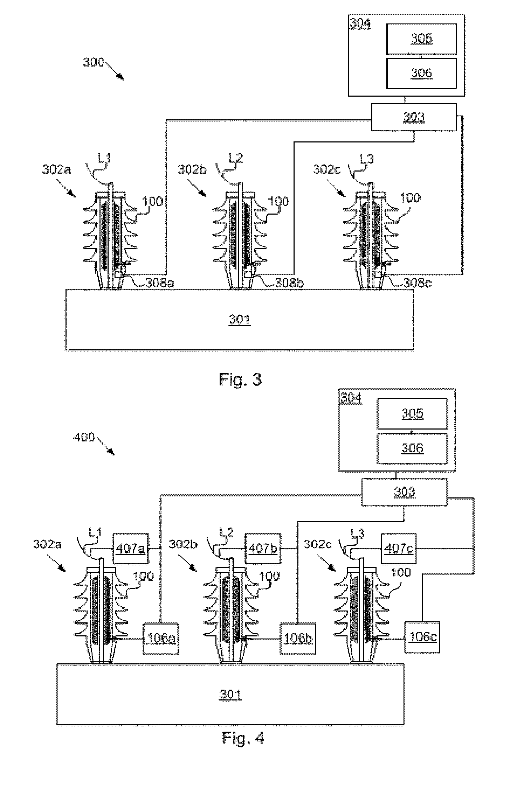

In Fig. 3 a system, generally designated 300, for monitoring three transformer bushings (100,302a-c) of a three phase transformer 301 is disclosed. The transformer 301 comprises three transformer bushings 302a-c. The first transformer bushing 302a is used to connect a first phase L1 to a corresponding transformer winding (not shown) of the transformer 301. The second transformer bushing 302b is used to connect a second phase L2 to a corresponding transformer winding (not shown) of the transformer 301. The third transformer bushing 302c is used to connect a third phase L3 to a corresponding transformer winding (not shown) of the transformer 301. Each transformer bushing 302a-c comprises a corresponding sensor device 308a-c. The corresponding sensor device may be configured for measuring a property of the transformer bushing, such as for example temperature, pressure or capacitance. Each sensor device 308a-c is connected to a measurement device 303. The measurement device is configured to obtain information about the measure property obtained by the sensor device.

Information about the measured property are used as an input to a processing device 304, the processing device 304 comprises a processor 305 and a memory 306. The memory 306 contains instructions such that when executed by the processor 305, corresponding measurement M1, M2, and M3 for each transformer bushing 302a-c are received by the processing device 304.

The measurements M1, M2, and M3 are indicate of the status of the transformer bushings 302a-c. The present invention is based on the insight that each of these measurements can be used as a measurements vector with a magnitude equal to the measurement and a direction that is selected such that the three measurement vectors are evenly angularly distributed on the unit circle with an angular difference of $2 \times \pi/3$ (120°) between adjacent measurement vectors.

By assuming that the measurement M1 has a direction angle of $\pi/2$ (90°), the measurement M2 has a direction angle of $7 \times \pi/6$ (210°), and the measurement M3 has a direction angle of $11 \times \pi/6$ (330°). This allows a measurement vector for each measurement M1-M3 to be defined $\overline{M1} = \{M1, \pi/2\}$, $\overline{M2} = \{M2, 7 \times \pi/6\}$, and $\overline{M3} = \{M3, 11 \times \pi/6\}$.

The introduced shorthand notation for vectors $\overline{X} = \{a, \alpha\}$ should be interpreted as a vector X with magnitude a and direction $\alpha$.

By summing these three vectors, a vector sum $\overline{M} = \overline{M1} + \overline{M2} + \overline{M3}$ is formed. This vector sum $\overline{M}$ has some interesting properties, for example if the vector sum $\overline{M}$ is equal to the null vector it means that all capacitances are equal to each other i.e. M1=M2=M3. Furthermore, by comparing the magnitude of the vector sum with a single threshold value a transformer bushing problem may easily be detected.

For a normal three phase high voltage transformer the vector sum $\overline{M}$ will not be equal to the null vector. This is due to the fact that the three transformer bushings will not exhibit exact the same capacitances. Instead some natural variations in the bushings capacitance exist. This means that variations over time in the vector sum $\overline{M}$ will be indicative of the time varying capacitances. In one embodiment moving average analysis of the vector sum $\overline{M}$ has proved to be useful in order to quantify the time varying capacitances.

In Fig. 4 an embodiment of a system, generally designated 300, for monitoring three transformer bushings (100,302a-c) of a three phase transformer 301 is disclosed. In this embodiment each transformer bushing comprises a sensor device 408a-c, wherein each sensor device 408a-c comprises a test tap adapter 105a-c connected to a corresponding load circuit 106a-c. Each load circuit 106a-c is connected to the measuring device 303. In a preferred embodiment the load circuit provides a corresponding voltage measured across the resistor of the load circuit 106a-c to the measuring device. Furthermore, the center core of each transformer bushing 302a-c is connected to a corresponding voltage transformer 307a-c, which provides a voltage proportional to the high voltage of each center core to the measurement device 303. This way the measurement device 303 is capable of measuring the voltage of the center core as well as the voltage of the test tap adapter of each bushing 302a-c.

Information about the measured voltages are used as an input to a processing device 304, the processing device 304 comprises a processor 305 and a memory 306. The memory 306 contains instructions such that when executed by the processor 305, corresponding capacitance C1, C2, and C3 for each transformer bushing 302a-c are calculated by means of the above measured voltages and the above equation (eq1).

The capacitances C1, C2, and C3 indicate the status of each transformer bushing 302a-c. The present invention is based on the insight that each of these capacitances can be used as a capacitance vector with a magnitude equal to the capacitance and a direction that is selected such that the three capacitance vectors are evenly angularly distributed on the unit circle with an angular difference of $2\times\pi/3$ (360°/3) between adjacent capacitance vectors.

By assuming that the capacitance C1 has a direction angle of 90 °, the capacitance C2 has a direction angle of 210 °, and the capacitance C3 has a direction angle of 330 °. This allows a capacitance vector for each capacitance C1-C3 to be defined $\overline{C1}$ ={C1, $\pi/2$}, $\overline{C2}$ ={C2, $7\times\pi/6$}, and $\overline{C3}$ ={C3, $11\times\pi/6$}.

By summing these three vectors, a vector sum $\overline{C} = \overline{C1} + \overline{C2} + \overline{C3}$ is formed.
This vector sum $\overline{C}$ has some interesting properties, for example if the vector sum $\overline{C}$ is equal to the null vector it means that all capacitances are equal to each other i.e. C1=C2=C3. Furthermore, by comparing the magnitude of the vector sum with a single threshold value a transformer bushing problem may easily be detected.

For a normal three phase high voltage transformer the vector sum $\overline{C}$ will not be equal to the null vector. This is due to the fact that the three transformer bushings will not exhibit exact the same capacitances. Instead some natural variations in the bushings capacitance exist. This means that variations over time in the vector sum $\overline{C}$ will be indicative of the time varying capacitances. In one embodiment moving average analysis of the vector sum $\overline{C}$ has proved to be useful in order to quantify the time varying capacitances.

In other embodiments, different phase angles can be selected for the capacitance vectors as long as they are evenly angularly distributed on the unit circle. This means that in a three phase system the difference in angle between the capacitors are 120 °. In a four phase system the difference in angle between the capacitors are 90 °.

In order to detect time varying transformer bushing problems a moving average filter may be used to detect variances in the measurement vector. In one embodiment is a sample size of one week used in the moving average calculation.

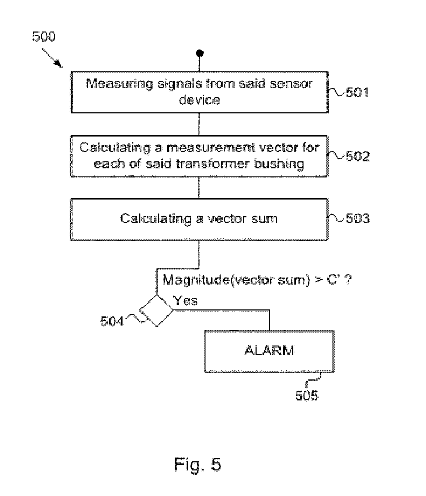

Fig. 5 is a flow diagram illustrating an embodiment of a method for monitoring transformer bushings (100,302a-c) of a three phase transformer, wherein each transformer bushing comprises a sensor device (308a-c,408a-c). The method comprising:

501: Measuring signals from said sensor devices.

502: Calculating a measurement vector for each of said three transformer bushings from the corresponding measured signal, wherein the magnitude of the respective measurement vector of a transformer bushing is the measurement, and the direction of the measurement vector is selected such that the three measurement vectors are evenly angularly distributed on the unit circle with an angular difference of $2/3\times\pi$ between adjacent measurement vectors;

503: Calculating a vector sum of the three measurement vectors.

504: Determining if the magnitude of the vector sum is larger than a predetermined value, then issue an alarm (405).

In one embodiment wherein the sensor device comprises a test tap adapter (105) and a load circuit (106) and each test tap adapter is connected to an electrical potential via a resistor (R1), wherein the measuring of a signal comprises measuring the voltage drop over a resistor (R1) of the load circuit (106), and the calculation of the measurement vector comprises calculating the capacitance between the center core (102) and the test tap adapter (105).

In one embodiment the calculation of the measurement vector comprises calculating the magnitude of the measurement vector as C'=U/($\omega$ *R*HV), wherein U is the voltage over the resistor (R1), R is the resistance of the resistor (R1), and HV is the incoming voltage to the transformer bushing, and $\omega$=2$\times\pi\times$f, where f is the frequency of the high-voltage.

In another embodiment, the sensor device is a temperature sensor, and the calculation of the measurement vector, comprises using the measured temperature as the magnitude of the corresponding measurement vector.

In yet another embodiment, the sensor device is a pressure sensor, and the calculation of the measurement vector, comprises using the measured pressure as the magnitude of the corresponding measurement vector.

From the description above it is apparent that an advantage of some embodiments described above is that they make it possible to monitor the transformer bushings in a multi-phase system in an effective and novel way that eliminates some of the problems associated with sum current measurements.

In an alternative embodiment may the processing device be a dedicated analogue circuit which implements the methods described herein by means of analogue components, such as comparators, operational amplifiers and phase locked loops.

In the drawings and specification, there have been disclosed typical embodiments and, although specific terms are employed, they are used in a generic and descriptive sense only and not for purposes of limitation, the scope of the invention being set forth in the following claims.

One embodiment of the invention is a computer readable media comprising instructions for a processor, wherein the instructions upon execution by the processor, causes the processor to perform a method for monitoring transformer bushings (100,302a-c) of a three phase transformer according to embodiments of the present invention.

**Claims**

1. A method (500) for monitoring transformer bushings (100,302a-c) of a three phase transformer, wherein each transformer bushing comprises a sensor device (308a-c,408a-c), the method comprising:

   measuring (501) signals from said sensor device;
   calculating (502) a measurement vector for each of said three transformer bushings from the corresponding measured signal, wherein the magnitude of the respective measurement vector of a transformer bushing is the measurement, and the direction of the measurement vector is selected such that the three measurement vectors are evenly angularly distributed on the unit circle with an angular difference of $2/3\times\pi$ between adjacent measurement vectors;
   calculating (503) a vector sum of the three measurement vectors;
   determining (504) if the magnitude of the vector sum is larger than a predetermined value, then issue an alarm (505).

2. A method according to claim 1, wherein the sensor device comprises a test tap adapter (105) and a load circuit (106)

3. A method according to claim 2, wherein each test tap adapter is connected to an electrical potential via a resistor (R1), wherein the measuring of a signal comprises measuring the voltage drop over a resistor (R1) of the load circuit (106), and the calculation of the measurement vector comprises calculating the capacitance between the center core (102) and the test tap adapter (105).

4. A method according to claim 3, wherein the calculation of the measurement vector comprises:

   calculating the magnitude of the measurement vector as C'=U/( $\omega$*R*HV),
   wherein U is the voltage over the resistor (R1), R is the resistance of the resistor (R1), and HV is the incoming voltage to the transformer bushing, and $\omega=2\times\pi\times f$, where f is the frequency of the high-voltage.

5. A method according to claim 1, wherein the sensor device is a temperature sensor, and the calculation of the measurement vector, comprises using the measured temperature as the magnitude of the corresponding measurement vector.

6. A method according to claim 1, wherein the sensor device is a pressure sensor, and the calculation of the measurement vector, comprises using the measured pressure as the magnitude of the corresponding measurement vector.

7. A method according to any preceding claim, further comprising calculating moving averages for the vector sum.

8. A system (300) for monitoring transformer bushings (100,302a-c) of a three phase transformer, wherein each transformer bushing comprises a respective sensor device (308a-c, 408a-c), the system comprising:

   a measuring device (303) for measuring signals from said sensor devices;
   and a processing means (304) configured for

   calculating measurement vector for each of said three transformer bushings from the corresponding measured signal, wherein the magnitude of the respective measurement vector of a transformer bushing is the measurement, and the direction of the measurement vector is selected such that the three measurement vectors are evenly angularly distributed on the unit circle with an angular difference of $2/3\times\pi$ between adjacent measurement vectors;
   calculating a vector sum of the of the three measurement vectors; determining if the magnitude of the vector sum is larger than a predetermined value, then issue an alarm.

9. A system (300) according to claim 8, wherein the sensor device comprises a test tap adapter (105) and a load circuit (106).

10. A system according to claim 9, wherein the load circuit comprises a resistor (R1) connected to a potential, wherein the measuring device is configured to measure the voltage drop over the resistor.

11. A system according to claim 10, wherein the processing means further is configured for calculating the magnitude of the measurement vector as C'=U/($\omega$*R*HV), wherein U is the voltage over the resistor, R is the resistance of the resistor, and HV is the incoming high voltage to the transformer bushing, and $\omega=2\times\pi\times f$, where f is the frequency of the high-voltage.

12. A system according to claim 8, wherein the sensor device is a temperature sensor, and the calculation of the measurement vector comprises using the measured temperature as the magnitude of the corresponding measurement vector.

13. A system according to claim 8 wherein the sensor device is a pressure sensor, and the calculation of the measurement vector comprises using the measured pressure as the magnitude of the corresponding measurement vector.

14. A computer readable media comprising instructions for a processor, wherein the instructions upon execution by the processor, causes the processor to perform a method for monitoring transformer bushings (100,302a-c) of a three phase transformer according to any of claims 1 to 7.

Fig. 1

Fig. 2

300

302a L1    100    308a
302b L2    100    308b
302c L3    100    308c

304
305
306
303

301

Fig. 3

400

304
305
306
303

302a L1    407a    100    106a
302b L2    407b    100    106b
302c L3    407c    100    106c

301

Fig. 4

500

Measuring signals from said sensor device ⟶ 501

Calculating a measurement vector for each of said transformer bushing ⟶ 502

Calculating a vector sum ⟶ 503

Magnitude(vector sum) > C' ?

504 ◇ ──Yes──→

ALARM

505

Fig. 5

| | Europäisches Patentamt European Patent Office Office européen des brevets | **EUROPEAN SEARCH REPORT** | Application Number EP 16 18 4275 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/234243 A1 (SANTOS EDUARDO PEDROSA [BR]) 29 September 2011 (2011-09-29) * paragraphs [0002], [0009], [0023], [0028] - paragraph [0033]; figures 1,2,4-6 * * paragraph [0037] - paragraph [0039] * * paragraph [0042] * | 1-10, 12-14 | INV. G01R31/12 ADD. G01R31/02 |
| X | EP 0 747 715 A2 (DOBLE ENG [US]) 11 December 1996 (1996-12-11) * page 2, line 43 - line 47; figures 1,3,4,7,8,10 * * page 3, line 29 - line 56 * * page 4, line 31 - page 5, line 4 * | 1,8 | |
| X | MARK F LACHMAN ET AL: "On-Line Diagnostics of High-Voltage Bushings and Current Transformers Using the Sum Current Method", IEEE TRANSACTIONS ON POWER DELIVERY, IEEE SERVICE CENTER, NEW YORK, NY, US, vol. 15, no. 1, 1 January 2000 (2000-01-01), XP011049771, ISSN: 0885-8977 * the whole document * | 1,7,8 | |
| X | WO 2015/071253 A1 (REINHAUSEN MASCHF SCHEUBECK [DE]) 21 May 2015 (2015-05-21) * page 12, line 3 - page 13, line 22 * * page 6, line 10 - line 24 * * page 20, line 25 - page 25, line 4 * | 1,4,8,11 | |

TECHNICAL FIELDS SEARCHED (IPC)

G01R

-/--

The present search report has been drawn up for all claims

| Place of search | Date of completion of the search | Examiner |
|---|---|---|
| Munich | 3 February 2017 | Hof, Klaus-Dieter |

EPO FORM 1503 03.82 (P04C01)

page 1 of 2

Europäisches
Patentamt

European
Patent Office

Office européen
des brevets

**EUROPEAN SEARCH REPORT**

Application Number

EP 16 18 4275

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARCOS E G ALVES ET AL: "EXPERIENCE WITH ON-LINE MONITORING OF CAPACITANCE AND TANGENT DELTA OF CONDENSIVE BUSHINGS", INTERNATIONAL COLLOQUIUM TRANSFORMER RESEARCH AND ASSET MANAGEMENT, 12 November 2009 (2009-11-12), page 14, XP055109410, * Section 2.2 "Operation philosophy for on-line monitoring"; figures 2,3 * ----- | 1,8 | |
| A | EP 2 194 389 A1 (ABB TECHNOLOGY LTD [CH]) 9 June 2010 (2010-06-09) * paragraph [0001] - paragraphs [0011], [0060]; figures 1-4 * ----- | 5,6 | |

TECHNICAL FIELDS
SEARCHED        (IPC)

The present search report has been drawn up for all claims

| Place of search | Date of completion of the search | Examiner |
|---|---|---|
| Munich | 3 February 2017 | Hof, Klaus-Dieter |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 18 4275

This annex lists the patent family members relating to the patent documents cited in the above-mentioned European search report.
The members are as contained in the European Patent Office EDP file on
The European Patent Office is in no way liable for these particulars which are merely given for the purpose of information.

03-02-2017

| Patent document cited in search report | | | Publication date | Patent family member(s) | | | Publication date |
|---|---|---|---|---|---|---|---|
| US 2011234243 | A1 | | 29-09-2011 | EP<br>US<br>WO | 2553480<br>2011234243<br>2011120112 | A1<br>A1<br>A1 | 06-02-2013<br>29-09-2011<br>06-10-2011 |
| EP 0747715 | A2 | | 11-12-1996 | EP<br>US | 0747715<br>6177803 | A2<br>B1 | 11-12-1996<br>23-01-2001 |
| WO 2015071253 | A1 | | 21-05-2015 | CN<br>DE<br>EP<br>JP<br>KR<br>US<br>WO | 106030738<br>102013112584<br>3069359<br>2017502455<br>20160086847<br>2016252564<br>2015071253 | A<br>A1<br>A1<br>A<br>A<br>A1<br>A1 | 12-10-2016<br>21-05-2015<br>21-09-2016<br>19-01-2017<br>20-07-2016<br>01-09-2016<br>21-05-2015 |
| EP 2194389 | A1 | | 09-06-2010 | AT<br>CN<br>EP<br>KR<br>US<br>WO | 504843<br>102239416<br>2194389<br>20110108343<br>2011301880<br>2010063519 | T<br>A<br>A1<br>A<br>A1<br>A1 | 15-04-2011<br>09-11-2011<br>09-06-2010<br>05-10-2011<br>08-12-2011<br>10-06-2010 |

EPO FORM P0459

For more details about this annex : see Official Journal of the European Patent Office, No. 12/82